# DEMANDE DE BREVET EUROPEEN

(11) **EP 0 711 043 A1**
(43) Date de publication de la demande: **08.05.1996**
(21) Numéro de dépôt: 95402432.9
(22) Date de dépôt: 02.11.1995
(51) Int. Cl.: H03M 1/12, G01R 13/02

(54) **Procédé d'optimisation d'un appareil de mesure numérique présentant deux modes, rapide et lent, de conversion analogique-numérique et appareil pour sa mise en oeuvre**

(30) Priorité: 07.11.1994 FR 19940013289
(71) Demandeur: METRIX, F-74600 Seynod (FR)
(72) Inventeur: Marmey, Stéphane, F-74600 Seynod (FR)
(74) Mandataire: Kohn, Philippe

(57) **Abrégé**

L'invention concerne un procédé d'optimisation d'un appareil de mesure numérique présentant deux modes, rapide et lent, de conversion analogique-numérique, **caractérisé en ce que** l'on effectue tout d'abord la mesure en mode rapide, en ce que l'on détermine la stabilité de la mesure, c'est-à-dire la variation entre des mesures successives, en ce que, lorsque cette stabilité devient inférieure à un seuil prédéterminé, on effectue la mesure en mode lent tout en déterminant la stabilité et en ce que, si la stabilité redevient supérieure audit seuil prédéterminé, on effectue la mesure en mode rapide.

L'invention a également pour objet un appareil de mesure pour la mise en oeuvre de c e procédé.

## Description

La présente invention concerne la mesure en continu d'une grandeur électrique au moyen d'un appareil de mesure numérique présentant deux modes de conversion analogique-numérique, à savoir un mode rapide à faible précision et un mode lent à précision élevée, en vue de la mesure en continu et/ou de la surveillance d'un paramètre.

Lorsque le paramètre à mesurer n'est pas stable, c'est-à-dire lorsqu'il varie rapidement avec des variations importantes, la mesure en mode lent n'est pas adaptée; en particulier, elle ne permet pas de suivre les variations; de plus il est inutile de mesurer avec une forte précision un paramètre instable. Par contre, lorsque le paramètre est relativement stable, c'est-à-dire que ses variations sont lentes et de faible amplitude, il est souhaitable de le mesurer avec une grande précision, c'est-à-dire en mode lent.

La présente invention a donc pour but de fournir un procédé qui permet d'optimiser le fonctionnement de l'appareil de en tenant compte de la stabilité du paramètre à mesurer.

Le procédé selon l'invention est notamment remarquable en ce que l'on effectue tout d'abord la mesure en mode rapide, en ce que l'on détermine la stabilité de la mesure, c'est-à-dire la variation entre des mesures successives, en ce que, lorsque cette stabilité devient inférieure à un seuil prédéterminé, on effectue la mesure en mode lent tout en déterminant la stabilité et en ce que, si la stabilité redevient supérieure audit seuil prédéterminé, on effectue la mesure en mode rapide.

De cette manière, on adapte le mode de conversion à la stabilité du paramètre, le mode lent n'étant sélectionné que lorsque le paramètre est suffisamment stable.

Selon une autre caractéristique de l'invention, la stabilité est déterminée entre deux mesures successives et le passage en mode lent n'est commandé que lorsque la stabilité est inférieure audit seuil pendant plusieurs mesures successives.

Ceci permet de ne passer en mode lent que si les variations du paramètre sont lentes.

Selon encore une autre caractéristique de l'invention, à la fin de chaque mesure, on effectue un changement de gamme de mesure si la valeur de la mesure est supérieure à une valeur maximale ou inférieure à une valeur minimale.

Ceci permet d'utiliser la gamme la plus adaptée à la valeur de chaque mesure.

Selon encore une autre caractéristique de l'invention, en cas de changement de gamme de mesure, l'appareil passe automatiquement en mode rapide.

De cette manière, lorsque la mesure suivante apparaîtra, elle sera transmise très rapidement à l'utilisateur et, si cette mesure n'est pas encore adaptée à la nouvelle gamme, un nouveau changement de gamme pourra être fait rapidement.

L'invention a également pour objet un appareil de mesure numérique présentant deux modes de conversion analogique-numérique, à savoir un mode rapide à faible précision et un mode lent à précision élevée, tel qu'un multimètre, pour la mise en oeuvre du procédé selon l'invention, caractérisé en ce qu'il comporte un compteur de stabilité qui, pendant la mesure en mode rapide, est incrémenté à chaque fois que la stabilité est inférieure audit seuil et est remis à zéro à chaque fois que la stabilité est supérieure audit seuil.

D'autres caractéristiques et avantages de l'invention ressortiront de la description qui suit d'un exemple de réalisation, faite en se référant aux dessins ci-annexés sur lesquels:
- la figure 1 est le schéma synoptique d'un multimètre numérique conforme à l'invention et
- les figures 2 à 4 illustrent le procédé selon l'invention.

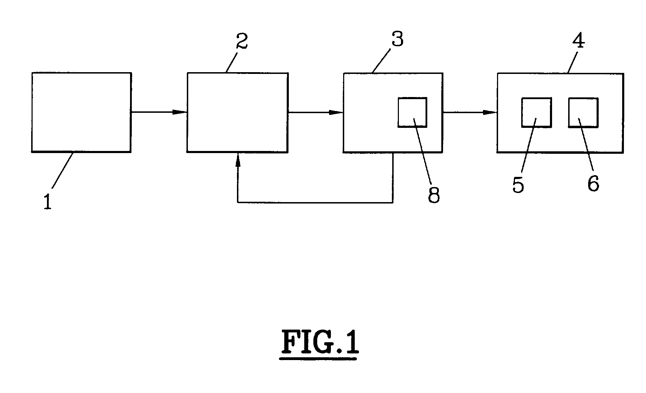

On voit sur la figure 1 un appareil de mesure, par exemple un multimètre numérique, qui comporte un module de mesure analogique 1, un convertisseur analogique-numérique 2 qui présente deux modes de conversion, à savoir un mode rapide à faible précision et un mode lent à précision élevée; le mode rapide effectue par exemple 20 mesures par seconde et sa précision est de 0,1 % ; le mode lent effectue deux mesures par seconde et sa précision est de 0,01 %.

Ce multimètre est commandé par un microprocesseur 3 qui commande le choix de la gamme de mesure et du mode de conversion; il élabore des signaux qui sont envoyés à un dispositif d'affichage 4 qui comporte deux afficheurs, un afficheur de type analogique 5, tel qu'un afficheur incrémental, communément appelé à barre graphe et un afficheur numérique 6. Le microprocesseur comporte également un compteur de stabilité 8 dont le fonctionnement sera expliqué plus bas en se référant au procédé selon l'invention.

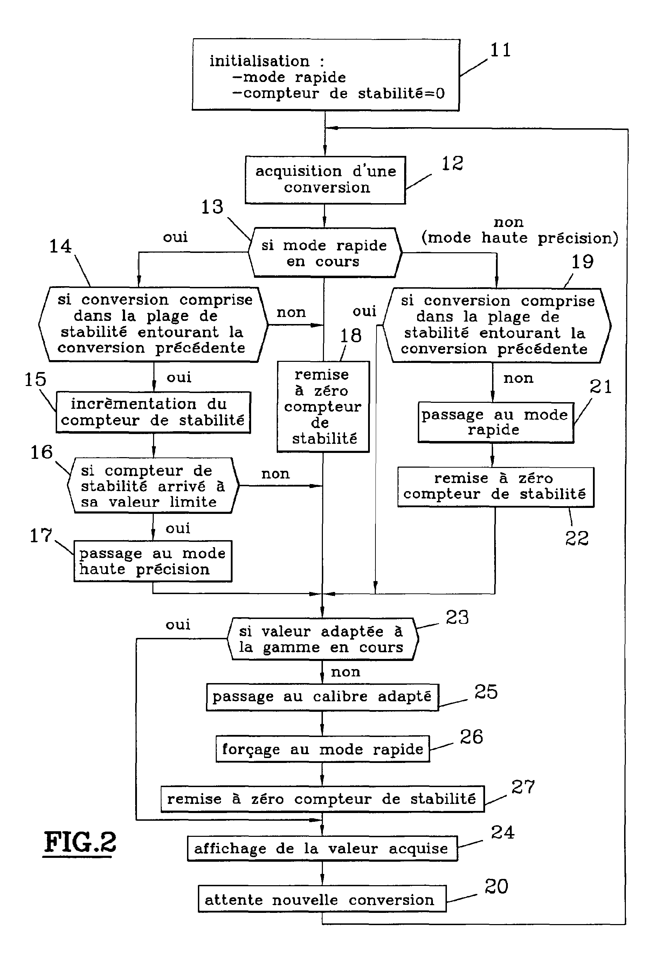

La figure 2 est l'ordinogramme du procédé selon l'invention. Dans une première étape d'initialisation 11, on sélectionne le mode rapide et le compteur de stabilité 8 est mis à zéro. Dans une deuxième étape 12, on commence la mesure avec l'acquisition d'une mesure. A la suite de cette étape qui est itérative, on détermine, dans une phase 13, si le mode rapide est sélectionné; si la réponse est positive, on effectue, dans une étape 14, un test de stabilité qui sera décrit en détail plus bas. Si ce test est positif, on incrémente le compteur de stabilité 8 (étape 15). On vérifie ensuite si le compteur est arrivé à sa valeur limite qui peut, par exemple, être fixée à 10 (étape 16).

Si le test de l'étape 16 est positif, on sélectionne le mode lent à haute précision (étape 17) et on passe à une phase de sélection automatique de gamme, du type décrit dans la demande de brevet français 2 639 119 de la demanderesse, et qui sera explicité plus bas.

Si le test de l'étape 14 est négatif, le compteur 8 est remis à zéro (étape 18) et on passe également à la phase de sélection automatique de gamme.

Si le test de l'étape 13 est négatif, cela signifie qu'il ne s'agit pas d'une première acquisition et que l'appareil est en mode lent à haute précision et l'on effectue, dans une étape 1, un test de stabilité (19). Si ce test est positif, on passe à la phase de sélection automatique de gamme.

Si le test de stabilité 19 est négatif, on passe aussitôt au mode rapide (étape 21), on remet à zéro le compteur de stabilité (étape 22) et on passe à la phase de sélection automatique de gamme.

La phase de sélection automatique de gamme est effectuée après chaque acquisition; elle comporte une étape 23 de test d'adaptation de la gamme de mesure qui sera expliqué en détail plus bas; si ce test est positif, on affiche la valeur acquise (étape 24) et on attend une nouvelle acquisition (étape 20) pour retourner à l'étape 12. Si le test 23 est négatif, on passe à la gamme adaptée à la mesure acquise (étape 25), puis on passe automatiquement au mode rapide (étape 26) avec mise à zéro du compteur de stabilité (étape 27) avant de passer à l'étape d'affichage 24.

Avantageusement, les valeurs acquises sont affichées par l'afficheur analogique à barre graphe 5 et seules les valeurs acquises en mode lent sont affichées par l'afficheur numérique 6.

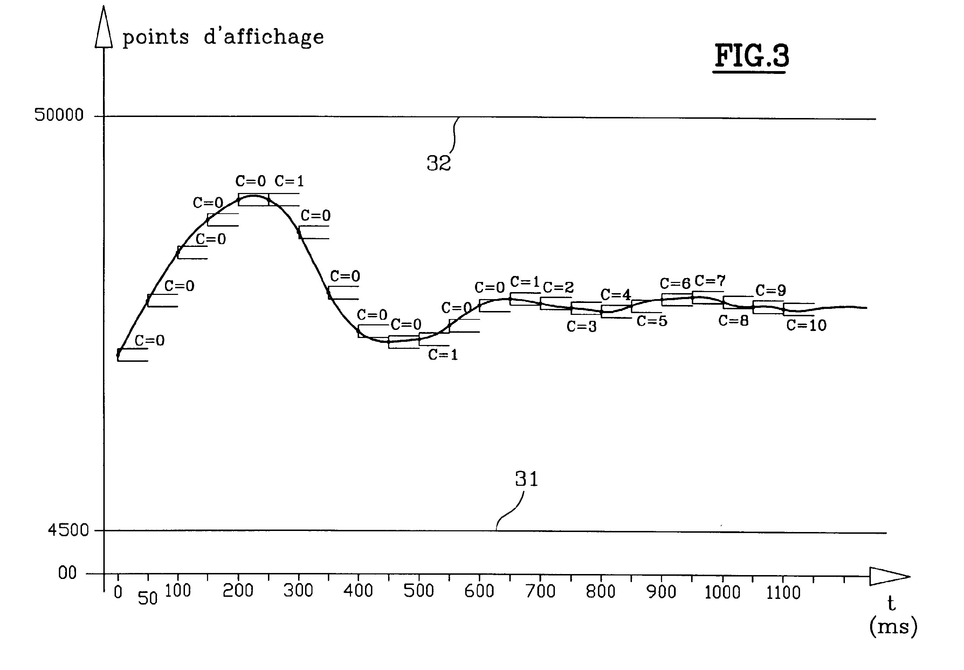

La figure 3 illustre le début d'une mesure en continu avec passage du mode rapide au mode lent. La courbe est la courbe enveloppe des valeurs acquises exprimées en nombre de points d'affichage en fonction du temps en microsecondes.

Le seuil de stabilité est déterminé par une variation de 100 points, par exemple, autour de chaque valeur acquise Cela détermine une fenêtre et le test de stabilité consiste à vérifier si la mesure suivante se trouve dans cette fenêtre qu est redéfinie pour chaque acquisition. Pour chaque acquisition on indique la valeur du compteur, C. On voit que ce test es positif une fois au niveau du maximum et une fois au niveau du minimum de la courbe et la valeur C passe à 1; ensuite, le tes est négatif et le compteur est remis à zéro.

Ensuite, le paramètre mesuré se stabilise et ne présent plus que des variations lentes et de faible amplitude; au bou de 10 test positifs (C = 10), on passe au mode lent et le compteur est remis à zéro.

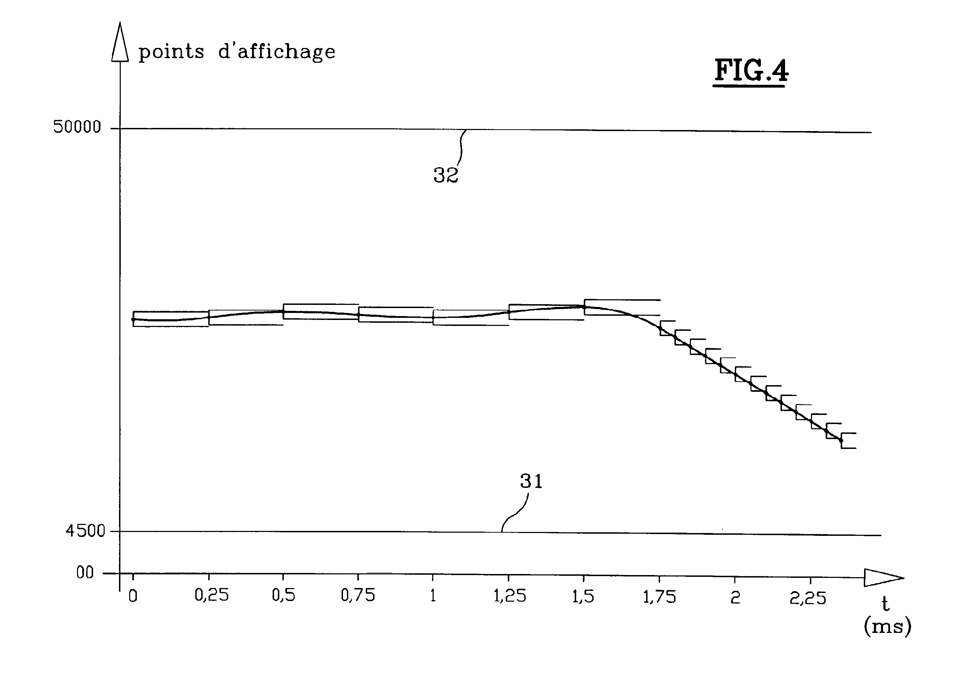

La figure 4 illustre un passage en mode rapide à parti d'une phase stable du paramètre. Ce passage s'effectue dès que le test de stabilité est négatif, le compteur de stabilité étant remis à zéro après chaque acquisition en mode lent.

Sur ces deux figures 3 et 4, on voit une limite inférieur 31 de changement automatique de gamme, par exemple à 4 500 points, et une valeur supérieure de changement automatique de gamme, par exemple fixée au nombre maxima de points d'affichage, 50 000 dans l'exemple décrit.

On voit que l'invention permet d'optimiser le fonctionnement d'un appareil de mesure numérique er adaptant le mode de conversion aux variations du paramètre à mesurer, le mode à haute précision n'étant sélectionné que s le paramètre est stable; par ailleurs, le changement automatique de gamme de mesure s'effectue en mode rapide de manière à sélectionner le plus rapidement possible la gamme la mieux adaptée.

Le fait de n'afficher de manière numérique que les valeurs acquises en mode lent permet d'éviter, en mode rapide, une succession rapide de valeurs numériques qui sont illisibles et créent un "scintillement" désagréable.

## Revendications

1. Procédé d'optimisation du fonctionnement d'un appareil de mesure numérique présentant deux modes de conversion analogique-numérique, à savoir un mode rapide à faible précision et un mode lent à précision élevée, en vue de la mesure en continu et/ou de la surveillance d'un paramètre, **caractérisé en ce que** l'on effectue tout d'abord la mesure en mode rapide, **en ce que** l'on détermine la stabilité de la mesure, c'est-à-dire la variation entre des mesures successives, **en ce que**, lorsque cette stabilité devient inférieure à un seuil prédéterminé, on effectue la mesure en mode lent tout en déterminant la stabilité et **en ce que**, si la stabilité redevient supérieure audit seuil prédéterminé, on effectue la mesure en mode rapide.

2. Procédé selon la revendication 1, **caractérisé en ce que** la stabilité est déterminée entre deux mesures successives et **en ce que** le passage en mode lent n'est commandé que lorsque la stabilité est inférieure audit seuil pendant plusieurs mesures successives.

3. Procédé selon la revendication 2, **caractérisé en ce que**, à la fin de chaque mesure, on effectue un changement de gamme de mesure si la valeur de la mesure est supérieure à une valeur maximale ou inférieure à une valeur minimale.

4. Procédé selon la revendication 3, **caractérisé en ce qu'**en cas de changement de gamme de mesure, l'appareil passe automatiquement en mode rapide.

5. Procédé selon la revendication 1, **caractérisé en ce qu'**en mode lent, on passe au mode rapide si la stabilité redevient supérieure audit seuil entre deux mesures successives.

6. Procédé selon la revendication 1, **caractérisé en ce que** les mesures sont affichées au moyen d'un afficheur analogique, tel qu'un afficheur incrémental, et **en ce que** les mesures en mode lent sont également affichées au moyen d'un afficheur numérique.

7. Appareil de mesure numérique présentant deux modes de conversion analogique-numérique, à savoir un mode rapide à faible précision et un mode lent à précision élevée, tel qu'un multimètre, pour la mise en oeuvre du procédé selon l'une quelconque des revendications 1 à 6, **caractérisé en ce qu'**il comporte un compteur de stabilité (8) qui, pendant la mesure en mode rapide, est incrémenté à chaque fois que la stabilité est inférieure audit seuil et est remis à zéro à chaque fois que la stabilité est supérieure audit seuil.

8. Appareil de mesure selon la revendication 7, **caractérisé en ce qu'**il comporte un convertisseur analogique-numérique (2) à deux modes de conversion.

9. Appareil de mesure selon la revendication 7, **caractérisé en ce qu'**il comporte deux dispositifs d'affichage, un afficheur incrémental (5) et un afficheur numérique (6), l'afficheur numérique (6) n'affichant que les valeurs de mesure en mode lent.
